# EUROPÄISCHE PATENTSCHRIFT

(11) **EP 3 338 061 B1**
(45) Veröffentlichungstag und Bekanntmachung des Hinweises auf die Patenterteilung: **12.06.2019**
(21) Anmeldenummer: 16751516.2
(22) Anmeldetag: 26.07.2016
(51) Int. Cl.: G01D 11/24, H05K 5/06, B29C 39/10, B29C 39/26, B29L 31/34, H05K 7/14

(54) **FELDGERÄT MIT EINEM BAUTEIL ZUM EINFÜLLEN VON VERGUSSMASSE**
FIELD DEVICE COMPRISING A COMPONENT FOR FILLING WITH A CASTING COMPOUND
APPAREIL DE TERRAIN POURVU D'UN ÉLÉMENT STRUCTUREL DESTINÉ AU REMPLISSAGE D'UN MATÉRIAU D'ENROBAGE

(30) Priorität: 21.08.2015 DE 102015113913
(43) Veröffentlichungstag der Anmeldung: 27.06.2018
(73) Patentinhaber: Endress+Hauser SE+Co. KG, 79689 Maulburg (DE)
(72) Erfinder: SEILER, Christian, 79424 Auggen (DE); HUWYLER, Willy, 6330 Cham (CH); MOSER, Silvio, 5406 Ruetihof (CH)
(74) Vertreter: Andres, Angelika Maria
(86) Internationale Anmeldenummer: PCT/EP2016/067748
(87) Internationale Veröffentlichungsnummer: WO 2017/032529

(56) Entgegenhaltungen:
- EP-A2- 2 884 826
- DE-A1- 10 116 019
- DE-A1-102013 208 534

## Beschreibung

Die Erfindung bezieht sich auf ein Feldgerät der Automatisierungstechnik mit einem geöffneten Gehäuse und einem Elektronikteil in dem Gehäuse, umfassend mindestens ein Bauteil zum Einfüllen einer Vergussmasse in das Gehäuse.

Sensoren oder Elektronikeinsätze werden in der Elektronik- oder Endfertigung aus verschiedenen Gründen wie z.B. Schutz vor Feuchtigkeit oder Explosionsschutz mit unterschiedlichsten Vergussmaterialien befüllt. Dabei wird die Vergussmasse in den meisten Fällen mit Hilfe der Schwerkraft unter Normalatmosphäre von oben in Gehäuseöffnungen eingegossen.

Die Offenlegungsschrift DE 10 116 019 A1 beschreibt beispielsweise einen modular aufgebauten Sensor mit einem becherartigen Element. Die Elektronik des Sensors ist in dem becherartigen Element aufgenommen und wird anschließend darin durch einen Verguss vergossen. Die Vergussmasse wird durch eine Einfüllöffnung eingefüllt, die z.B. am oberen Rand des becherartigen Elements angeordnet ist.

Dabei fließt das Material relativ unkontrolliert um die im Gehäuse vorhandenen Elektronikteile herum und sucht sich seine Wege. Lufteinschlüsse und Blasenbildung können durch dieses Verfahren nicht immer ausgeschlossen werden, so dass verschiedene Ansätze zur Vermeidung der Blasen und Lufteinschlüsse zur Anwendung kommen können. Beispiele sind Befüllung unter Vakuum, lange Standzeiten nach Verguss (Blasen sollen aufsteigen), stufenweises Vergießen (mit Standzeiten), Verguss unter Vibration, Befüllung unter Druck.

Die beschriebenen Methoden liefern oft nicht reproduzierbare Ergebnisse bzw. erlauben keine hohen Verarbeitungsgeschwindigkeiten, da es zu Rückstau durch Engpässe im Gehäuse kommen kann oder die Luft bei engen Einfüllstellen nicht ausreichend entweichen kann. Werden zusätzliche Maßnahmen angewendet, sind höhere Kosten des Produktes die Folge.

DE 10 2008 043169 A1 beschreibt eine Vorrichtung mit einem Gehäuse, das eine Öffnung aufweist. Das Gehäuse weist einen ersten Gehäuseabschnitt auf, in dem eine Sensorelektronik angeordnet ist. Ein Einsatz ist in den ersten Gehäuseabschnitt eingesetzt, wobei der Einsatz aus einem rohrförmigen Grundkörper besteht. Ein Befüllrohr ist in den Einsatz eingebracht, welches dazu dient, den Einsatz mit einer ersten Vergussmasse zu befüllen. Das in den Einsatz integrierte Befüllrohr ermöglicht ein Einfüllen der Vergussmasse in den Einsatz, ohne dass Lufteinschlüsse entstehen.

Nachteilig bei der Verwendung eines Befüllrohres ist, dass aus Platzgründen ein meist sehr kleiner Durchmesser des Befüllrohres verwendet werden muss. Die kleine Öffnung erfordert die Befüllung unter Druck durchzuführen, um eine ausreichende Befüllgeschwindigkeit gewährleisten zu können. Die Schnittstelle zwischen Befüllrohr und Vergussmaschine muss entsprechend formschlüssig sein, was eine sehr präzise Ausrichtung einer Füllnadel erfordert. Weiterhin nachteilig an solch einem Befüllrohr ist, dass es nach dem Befüllen des Gehäuses mit Vergussmasse in dem Gehäuse verbleibt, da ein Herausziehen des Befüllrohrs aus der Vergussmasse mehr Luft in die Vergussmasse einschließen würde.

In der Offenlegungsschrift DE 10 2013 208 534 A1 ist eine Gussform zum Herstellen einer Dichtung aus Vergussmasse beschrieben. Die Vergussmasse wird über einen einzigen von mehreren Dichtungsaufnahmekanälen an einen Einspritzpunkt eingeleitet, bis alle Dichtungsaufnahmekanäle mit der Vergussmasse gefüllt sind. Damit wird gezielt eine von der Gussform vorgegebene Form der Dichtung erreicht. Die Verwendung einer Gussform ist jedoch aus Platzgründen nicht immer möglich.

Die Patentanmeldung EP 2 884 826 A2 offenbart ein Gerät zum Einfüllen von Vergussmasse mit einem geöffneten Gehäuse und einem Elektronikteil in dem Gehäuse, umfassend mindestens ein Bauteil zum Einfüllen von Vergussmasse in das Gehäuse, wobei das Bauteil eine Rinne aufweist, um die Vergussmasse gezielt an eine zu vergießende Stelle des Gehäuses zu leiten. Diese Lösung ist allerdings nicht praktikabel für ein Einfüllen von Vergussmasse durch enge Öffnungen, da hier die Rinne schwer zugänglich ist.

Der Erfindung liegt die Aufgabe zugrunde, ein Feldgerät der Automatisierungstechnik anzugeben, welches ein schnelles Einfüllen von Vergussmasse in das Gehäuse des Feldgeräts auch durch enge Öffnungen ermöglicht, ohne dass Lufteinschlüsse in der Vergussmasse entstehen.

Die Aufgabe der Erfindung wird durch den Gegenstand der Erfindung gelöst. Gegenstand der Erfindung ist ein Feldgerät der Automatisierungstechnik mit einem geöffneten Gehäuse und einem Elektronikteil in dem Gehäuse, umfassend mindestens ein Bauteil zum Einfüllen von Vergussmasse in das Gehäuse, wobei das Bauteil eine Rinne aufweist, um die Vergussmasse gezielt an eine zu vergießende Stelle des Gehäuses zu leiten, und wobei die Rinne eine Auffangschale aufweist, die in Richtung einer Gehäuseöffnung weist, und einen Kanal, der in Richtung eines Gehäuseinneren weist.

Das erfindungsgemäße Feldgerät ermöglicht eine gezielte Befüllung und Entlüftung des Gehäuses, ohne dass die Vergussmasse verwirbelt wird. Ferner wird die Blasenbildung unterdrückt, wodurch Lufteinschlüsse vermieden werden.

Gemäß einer vorteilhaften Ausgestaltung ist das Bauteil als eine Kabelhalterung für mindestens ein in das Gehäuse zu führendes Kabel ausgestaltet.
Gemäß einer vorteilhaften Variante ist der Kanal dermaßen dimensioniert, dass die Vergussmasse an einen zu vergießenden Spalt, beispielsweise einen Spalt zwischen dem Elektronikteil und einer Innenwandung des Gehäuses, geführt wird, damit die Vergussmasse geordnet herunterlaufen kann.

Gemäß einer vorteilhaften Weiterbildung weist das Bauteil mindestens eine Öffnung zum Entlüften des Gehäuses auf.

Gemäß einer günstigen Ausgestaltung ist die Auffangschale neben der mindestens einen Öffnung angeordnet.

Gemäß einer günstigen Ausführungsform verläuft die Auffangschale um die mindestens eine Öffnung herum.

Die Erfindung wird anhand der nachfolgenden Zeichnungen näher erläutert. Es zeigt:
Fig. 1: eine perspektivische Ansicht auf das Bauteil eines Feldgeräts der Automatisierungstechnik, und
Fig. 2: eine perspektivische Ansicht auf ein durchsichtiges Gehäuse eines Feldgeräts der Automatisierungstechnik.

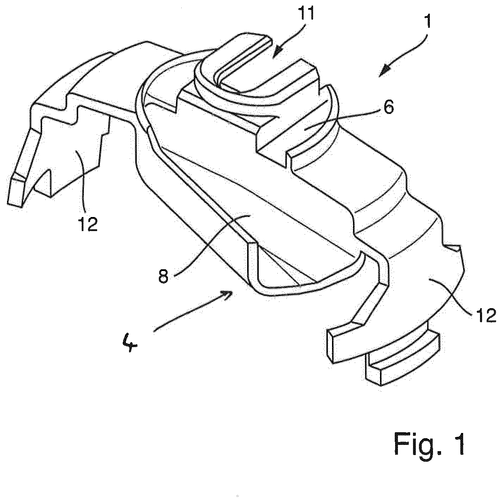

Fig. 1 zeigt ein Bauteil 1 für ein Gehäuse (nicht dargestellt) eines Feldgeräts der Automatisierungstechnik (nicht dargestellt). Bauteil 1 dient einerseits zum Einfüllen von Vergussmasse in das Gehäuse und andererseits als Kabelhalterung. Zum Halten eines Kabels (nicht dargestellt) weist das Bauteil 1 eine Öffnung 11 auf.

Das Bauteil 1 weist eine Rinne 4 auf, die eine Auffangschale 6 und einen Kanal 8 umfasst. Die Auffangschale 6 ist in einem oberen Bereich des Bauteils 1 angeordnet und verläuft um die Öffnung 11 herum und mündet in den Kanal 8, der in einem unteren Bereich des Bauteils 1 angeordnet ist. Ferner weist das Bauteil 1 Halterungen 12 zum Befestigen an einem Gehäuse (nicht dargestellt) auf.

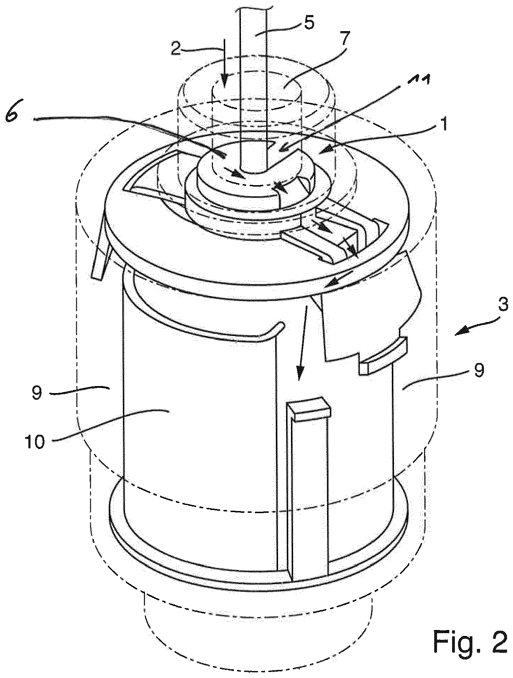

Fig. 2 zeigt eine perspektivische Ansicht auf ein durchsichtiges Gehäuse eines Feldgeräts der Automatisierungstechnik. In dem Gehäuse 3 ist ein Bauteil 1 entsprechend Fig. 1 eingebaut. Das Bauteil 1 ist als eine Kabelhalterung für ein Kabel 5 ausgestaltet. Das Gehäuse 3 weist eine Gehäuseöffnung 7 auf, in deren Richtung die Auffangschale 6 des Bauteils 1 gerichtet ist. Folglich ist der Kanal (nicht dargestellt) des Bauteils 1 in Richtung des Gehäuseinneren gerichtet. Selbstverständlich kann das Gehäuse neben mehreren Bauteilen auch ein Bauteil mit mehreren Auffangschalen oder mehreren Kanälen aufweisen.

Im Gehäuseinneren des Gehäuses 3 ist ein Elektronikteil 10 angeordnet. Auf diese Weise entsteht ein Spalt 9 zwischen der Innenwandung des Gehäuses 3 und dem Elektronikteil 10. Das Vergießen der Vergussmasse in das Gehäuse 3 des Feldgeräts läuft folgendermaßen ab: Die flüssige Vergussmasse wird durch die Gehäuseöffnung 7 in die Auffangschale 6 des Bauteils 1 gegossen. Die flüssige Vergussmasse fließt von der Auffangschale 6 in den Kanal (nicht sichtbar) des Bauteils 1. Die Fließrichtung der Vergussmasse ist durch Pfeile dargestellt. Der Kanal leitet die Vergussmasse an den Spalt zwischen dem Elektronikteil 10 und der Innenwandung des Gehäuses 3. Die Vergussmasse fließt in den Spalt 9, wobei die verdrängte Luft durch die Öffnung 11 des Bauteils 1 und der Gehäuseöffnung 7 entweichen kann.

### Bezugszeichenliste

- 1: Bauteil
- 2: Vergussmasse
- 3: Gehäuse
- 4: Rinne
- 5: Kabel
- 6: Auffangschale
- 7: Gehäuseöffnung
- 8: Kanal
- 9: Spalt
- 10: Elektronikteil
- 11: Öffnung
- 12: Halterung

## Patentansprüche

1. Feldgerät der Automatisierungstechnik mit einem geöffneten Gehäuse (3) und einem Elektronikteil (10) in dem Gehäuse (3), umfassend
mindestens ein Bauteil (1) zum Einfüllen von Vergussmasse (2) in das Gehäuse (3), wobei das Bauteil (1) eine Rinne (4) aufweist, um die Vergussmasse (2) gezielt an eine zu vergießende Stelle des Gehäuses (3) zu leiten,
**dadurch gekennzeichnet,**
**dass** die Rinne (4) eine Auffangschale (6) aufweist, die in Richtung einer Gehäuseöffnung (7) weist, und einen Kanal (8) aufweist, der in Richtung eines Gehäuseinneren weist.

2. Feldgerät nach Anspruch 1, wobei das Bauteil (1) als eine Kabelhalterung für mindestens ein in das Gehäuse (3) zu führendes Kabel (5) ausgestaltet ist.

3. Feldgerät nach Anspruch 1, wobei der Kanal (8) dermaßen dimensioniert ist, dass die Vergussmasse (2) an einen zu vergießenden Spalt (9), beispielsweise einen Spalt (9) zwischen dem Elektronikteil (10) und einer Innenwandung des Gehäuses (3), geführt wird, damit die Vergussmasse (2) geordnet herunterlaufen kann.

4. Feldgerät nach mindestens einem der vorhergehenden Ansprüche, wobei das Bauteil (1) mindestens eine Öffnung (11) zum Entlüften des Gehäuses (3) aufweist.

5. Feldgerät nach mindestens einem der Ansprüche 1 bis 5, wobei die Auffangschale (6) neben der mindestens einen Öffnung (11) angeordnet ist.

6. Feldgerät nach mindestens einem der Ansprüche 1 bis 5, wobei die Auffangschale (6) um die mindestens eine Öffnung (11) herum verläuft.

## Claims

1. Field device used in automation engineering with an open housing (3) and an electronics module (10) in the housing (3), comprising
at least one component (1) designed to pour potting compound (2) into the housing (3), wherein the component (1) has a duct (4) designed to conduct the potting compound (2) in a targeted manner to a point of the housing (3) that is to be sealed,
**characterized in that**
the duct (4) has a collection tray (6) that points in the direction of a housing opening (7), and has a channel (8) that points in the direction of the housing interior.

2. Field device as claimed in Claim 1, wherein the component (1) is designed as a cable holder for at least one cable (5) to be routed into the housing (3).

3. Field device as claimed in Claim 1, wherein the channel (8) is sized in such a way that the potting compound (2) is guided to a gap (9) to be sealed, for example a gap (9) between the electronics module (10) and an internal wall of the housing (3), so that the potting compound (2) can flow down in an orderly fashion.

4. Field device as claimed in at least one of the previous claims, wherein the component (1) has at least one opening (11) to vent the housing (3).

5. Field device as claimed in at least one of the Claims 1 to 4, wherein the collection tray (6) is arranged beside the at least one opening (11).

6. Field device as claimed in at least one of the Claims 1 to 5, wherein the collection tray (6) extends around the at least one opening (11).

## Revendications

1. Appareil de terrain de la technique d'automatisation avec un boîtier ouvert (3) et un module électronique (10) logé dans le boîtier (3), comprenant
au moins un composant (1) destiné au remplissage d'une masse de scellement (2) dans le boîtier (3), le composant (1) présentant un conduit (4) afin de diriger la masse de scellement (2) de façon ciblée à un endroit à sceller du boîtier (3), **caractérisé**
**en ce que** le conduit (4) comprend un récipient de récupération (6), qui est orienté en direction d'une ouverture de boîtier (7), et comprend un canal (8) qui est orienté en direction d'un intérieur du boîtier.

2. Appareil de terrain selon la revendication 1, pour lequel le composant (1) est conçu en tant que fixation de câble pour au moins un câble (5) à poser dans le boîtier (3).

3. Appareil de terrain selon la revendication 1, pour lequel le canal (8) est dimensionné de telle sorte que la masse de scellement (2) est guidée au niveau d'une fente (9) à sceller, par exemple une fente (9) entre le module électronique (10) et une paroi interne du boîtier (3), afin que la masse de scellement puisse s'écouler vers le bas de façon ordonnée.

4. Appareil de terrain selon au moins l'une des revendications précédentes, pour lequel le composant (1) présente au moins une ouverture (11) destinée à la purge du boîtier (3).

5. Appareil de terrain selon au moins l'une des revendications 1 à 4, pour lequel le récipient de récupération (6) est disposé à côté de l'au moins une ouverture (11).

6. Appareil de terrain selon au moins l'une des revendications 1 à 5, pour lequel le récipient de récupération (6) s'étend autour de l'au moins une ouverture (11).
